# EUROPEAN PATENT SPECIFICATION

(11) **EP 0 396 248 B1**
(45) Date of publication and mention of the grant of the patent: **26.01.1994**
(21) Application number: 90303252.2
(22) Date of filing: 27.03.1990
(51) Int. Cl.: H01R 13/04

(54) **Electrical pin and method for making same**
Elektrischer Steckerstift und Verfahren zu seiner Herstellung
Contact électrique à broche et méthode de sa fabrication

(30) Priority: 17.04.1989 JP 97009/89
(43) Date of publication of application: 07.11.1990
(73) Proprietor: THE WHITAKER CORPORATION, Wilmington, Delaware 19808 (US)
(72) Inventor: Nakamura, Keiichi, Tokyo (JP); Oshima, Tsutomu, Tokyo (JP); Kitai, Toshihiko, Isehara-shi, Kanagawa (JP); Fukuda, Katsunori, Sagamihara-shi, Kanagawa (JP)
(74) Representative: Warren, Keith Stanley

(56) References cited:
- DE-A- 3 329 115
- US-A- 3 561 107
- IBM TECHNICAL DISCLOSURE BULLETIN vol. 19, no. 3, August 1976, pages 836,837, New York, US; J.A. LAU et al.: "Multiple pin loader for specialized packaging applications"

## Description

This invention relates to an electrical pin, an assembly of such pins and a method for making the assembly. More specifically, the invention relates to micro I/O pins primarily for interconnecting electrodes between a chip device such as a monolithic or hybrid IC (integrated circuit) and its packaging substrate.

Conventionally, it is typical to install a chip device such as a monolithic or hybrid IC onto a package substrate by mounting such chip device at a predetermined position on such package substrate and wirebonding between printed circuits on the substrate and the chip electrodes.

However, hybrid ICs are performing increased multiple functions, have higher packaging density and are more compact for rapidly-expanding applications for consumer electronic appliances. As a result, stronger needs arise for compact and less-expensive interconnections of such chip devices.

Conventional wirebonding means require bridging between electrodes of the package substrate and the chip device with fine gold or similar lead wires and subsequently welding at each junction point (see US-A-3 561 107). Such chip packaging is slow and occupies a relatively large area on the precious chip substrate for such junction points, thereby making it more difficult to meet the aforementioned requirements. Additionally, such wirebonding limits signal propagation speed.

It has been proposed to directly weld electrodes of chip devices and package substrates in order to meet the requirements. This requires miniature electrical pins for interconnecting the electrodes therebetween.

It is, therefore, an object of this invention to provide miniature, less expensive and higher signal propagation speed electrical pins particularly suited for directly connecting chip devices and package substrates in these types of IC devices.

It is another object of this invention to provide a method of making an assembly of such electrical pins without using photo etching.

From one aspect, the present invention consists in an electrical pin comprising an electrically-conductive pin member and electrically-conductive head members formed at both ends of said pin member, characterized in that said pin member is substantially the same diameter over the entire length and said head members have an enlarged surface greater in diameter than said pin member and in the same plane of the end surfaces of said pin member.

At least one end surface of the enlarged end surfaces of the head members may be coated with a film electrode material for protecting oxidation of such end surface.

It is preferable that a large number of such pins are supported at one end surface on the support and, from another aspect, the invention consists in an assembly of electrical pins, each electrical pin comprising an electrically-conductive pin member and electrically-conductive head members at both ends of said pin member, characterized in that each pin member is substantially the same diameter over the entire length and said head members have an enlarged surface greater in diameter than the pin member, and means maintains the electrical pins in alignment at a predetermined pitch, said means comprising an electrically-conductive layer disposed on the head members at one end of said pin members and a dielectric member secured to said electrically-conductive layer.

Such an assembly simplifies the operation of directly mounting the pins onto a carrier, such as, a chip device or a printed circuit board.

From a further aspect, the invention consists in a method of making the above described electrical pin assembly, comprising the steps of arranging wire members having metal pin members coated with a layer of different metal in alignment at a predetermined pitch, applying a dielectric material to the arrangement of wire members which upon hardening forms an elongated member, slicing the elongated member perpendicular to the wire members to obtain a processing member having a thickness equal to the length of the electrical pins, removing said metal layers of said wire members at both ends of said pin members thereby forming recesses around both ends of the pin member, plating a conductive metal in said recesses forming head members secured to the ends of the pin members, disposing an electrically-conductive layer on the head members at one end of the pin members, and removing the dielectric material and the metal layers.

Embodiments of this invention will now be described by way of example with reference to the accompanying drawings, in which:-

FIGS. 1 and 2 are perspective views partly in cross section of different embodiments of the electrical pins according to the present invention.

FIGS. 3 through 19 illustrate the steps of making the electrical-pins according to the present invention.

FIGS. 20 through 22 illustrate the steps of installing the electrical pins of the present invention onto a substrate.

FIGS. 23 through 30 illustrate the steps of forming electrical junction points on a package substrate.

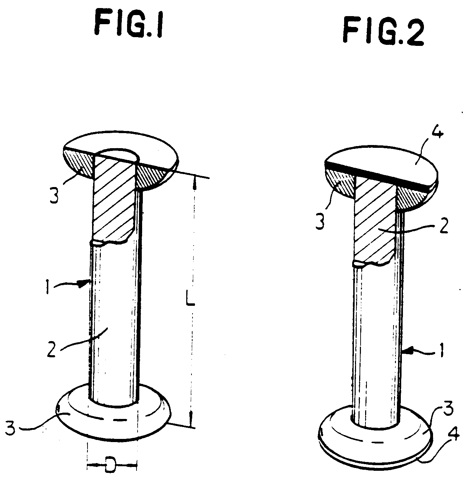

Illustrated in FIGS. 1 and 2 are two embodiments of the electrical pin according to the present invention. The pin 1 in FIG. 1 comprises an electrically-conductive pin member 2 and electrically-conductive head members 3 at both ends of the pin member, the head members 3 being of larger diameter than the pin member. The pin 1 in FIG. 2 has an electrically-conductive film 4 on the outer surface of the head members 3 acting as an oxidation protection film. The pin member 2 is made of an electrically-conductive metal such as copper or its alloy. Its length L and diameter D are, for example, about 0.6-0.9 mm and 0.1 mm, respectively. The diameter includes a circumferential gold-plated layer of 0.1 µm in thickness. The head members 3 are an electrically-conductive layer, such as copper, that is integrally formed on the circumferential surface of the edge portions of the pin member 2. The electrically-conductive film 4 is made of an alloy, for example, gold and tin. The transverse cross sections of the pin member 2 and the head members 3 are preferably circular but may be any other shape.

Although not shown in FIGS. 1 and 2, either one of the end surfaces of the electrically-conductive pin member 2 may be constructed in one of the above modes and the other end surface in the other mode in a further embodiment.

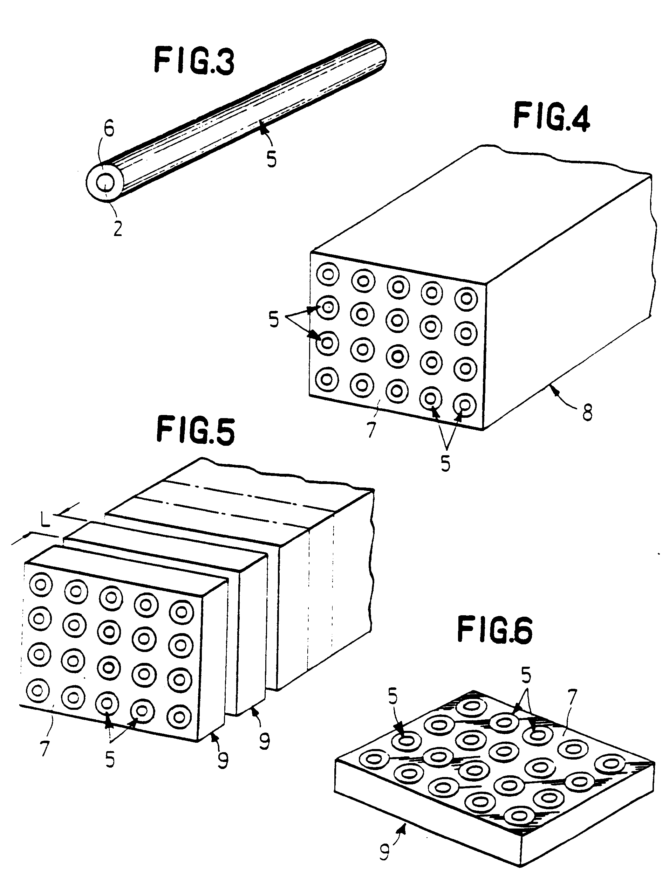

Illustrated in FIGS. 3 through 30 are basic steps common to the above modes of making the electrical pin.

Shown in FIG. 3 is a metal wire 5 to be the aforementioned electrically-conductive pin member 2. The wire 5 is an elongated wire of the above pin member 2 plated with a 0.1 mm thick layer 6 of tin or iron.

A plurality of such wires 5 are disposed between both ends of a holder (not shown) at a predetermined pitch (equal to the pitch of electrodes on a wiring board). Then, the holder is filled with a conventional dielectric material 7 such as a resin and the resin is hardened as an elongated member 8 as shown in FIG. 4.

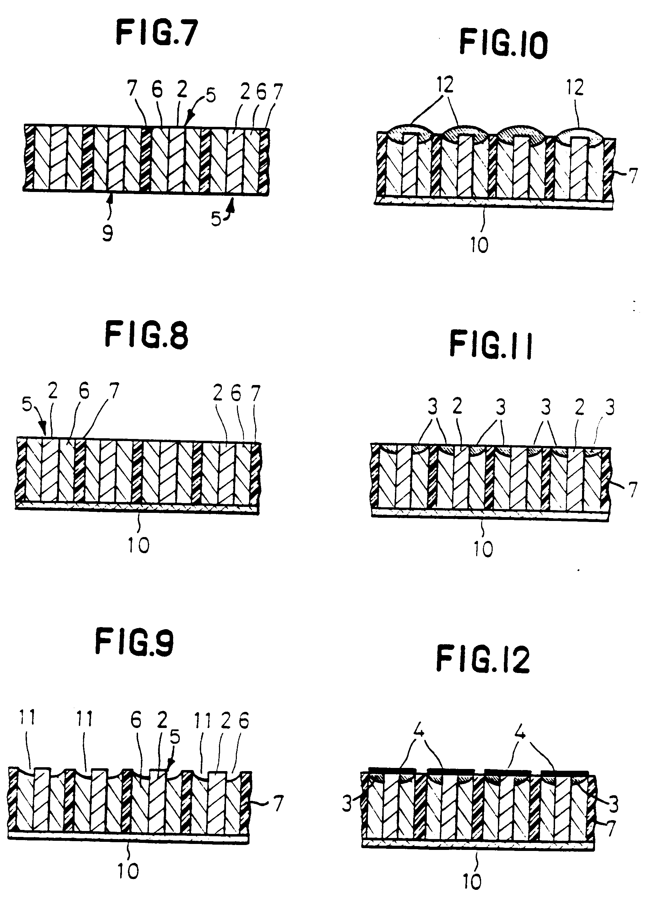

The hardened member 8 is sliced at a predetermined length L of the pin members 2 perpendicular to the length of the arranged wires 5 as shown in FIG. 5, thereby providing processing members 9. Illustrated in FIG. 6 is one of such sliced processing members 9 which comprises a predetermined number of pin members 2 having both ends extending to upper and lower surfaces of the member 9 while being buried therein. A part of the cross section of the processing member 9 is illustrated in a magnified form in FIG. 7. In this condition, both upper and lower surfaces of the processing member 9 are polished to normalize the thickness and to smooth the surfaces.

The processing member 9 is then transported to subsequent processing steps as illustrated in FIGS. 8-19.

In the step of FIG. 8, an electrically-conductive layer 10 is formed by coating or depositing silver paste on the bottom surface of the processing member 9.

In the step of FIG. 9, the processing member 9 is dipped in an etching liquid for etching the plated layer 6 at the exposed surface of the processing member 9. As time elapses, dish-like recesses 11 around the pin members 2 are formed in the exposed surface, the recesses 11 being relatively deep at the periphery of each pin member 2 due to its electrical conductivity but relatively shallow at the non-electrical conductive resin 7.

Subsequently, in FIG. 10, electrical current is supplied to the electrically-conductive layer 10 as a common electrode while dipping the processing member 9 in a plating bath. Copper-plated members 12 are formed onto the ends of the pin members 2 exposed in the recesses 11. The copper-plated members 12 are polished along the surface of the processing member 9 to obtain the electrically-conductive head members 3 with smooth outer surfaces as illustrated in FIG. 11.

In FIG. 12, a gold-plated, electrically-conductive film 4 is formed on the polished surfaces of the head members 3 as an electrode material for oxidation protection purposes. This step is adopted to protect oxidation of the end surfaces of the pin members 2 and the head members 3 during delivery or storage before actual use of the pins 1.

It is, therefore, understood that the last mentioned step may be eliminated in the event that the pins are used immediately after making, thereby avoiding oxidation of the end surfaces.

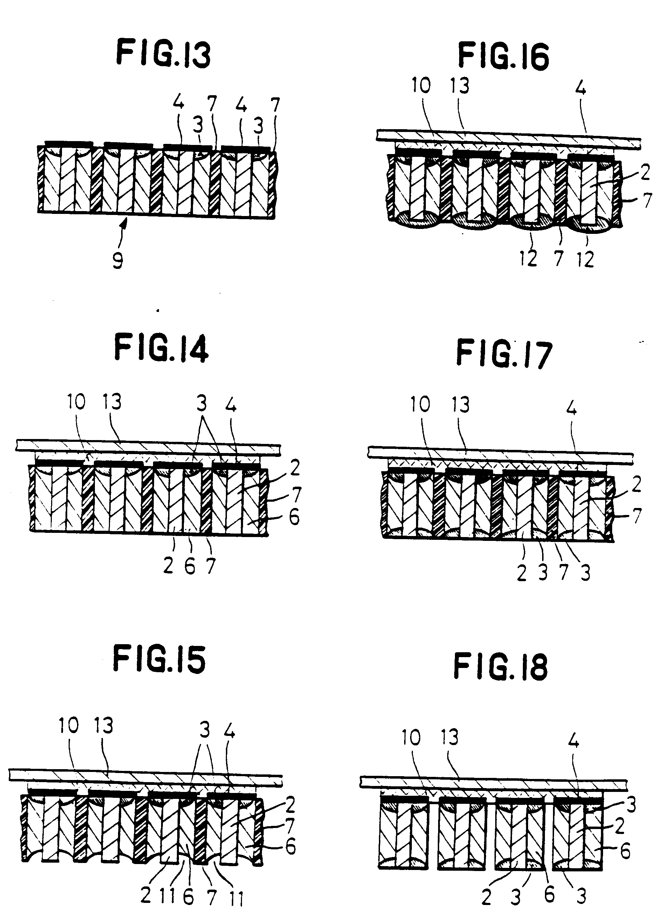

Illustrated in FIGS. 13 through 17 are the steps of providing similar head members 3 on the other surface of the processing member 9 to form the head members on the ends of the pin members 2 at the other surface.

Such additional steps are as follows: In FIG. 13, the electrically-conductive layer 10 acting as the common electrode for electro-plating is removed by conventional practices from the processing member 9 and the electrically-conductive layer 10 is formed on the other surface. Additionally, a ceramic plate 13 is adhered to the layer 10 for maintaining the alignment of the pin members 2 during subsequent processing and installation on a substrate.

Consequently, recesses 11 are formed in the other surface by fetching (FIG. 15), copper-plated portions 12 are formed in the recesses 11 and on the peripheries of pin members 2 (FIG. 16) and finally the head members 3 are completed on the other surface of the processing member 9 as shown in FIG. 17.

A gold-plated, electrically-conductive film 4 is provided on the end surfaces of the newly-formed head members 3 at this stage in order to obtain the particular pin 1 as illustrated in FIG. 2.

In FIG. 18, the resin between the arranged metal wires 5 in the processing member 9 is dissolved using an appropriate organic solution such as an aromatic or hydrocarbon solution. Although space is created between adjacent metal wires 5 by removing the resin, the metal wires 5 remain in their positions because of the ceramic plate 13.

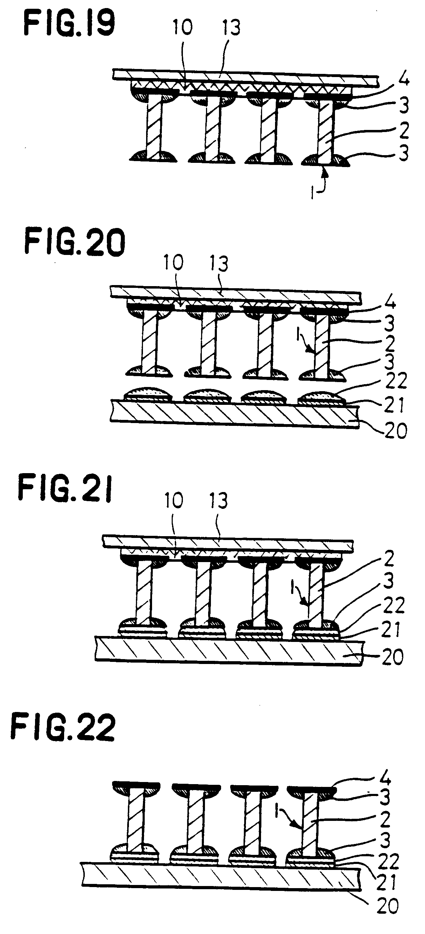

FIG. 19 shows a finishing step to fill a dissolving liquid in the space of the resin for completely dissolving the plated layer 6 on the outer surface of the pin members 2. As a result, the arranged pins 1 without the plated layers 6 remain on the ceramic plate 13.

The pins 1 may be coated with the electrically-conductive film 4 on one end surface as shown in this embodiment, or coated with film 4 on both end surfaces. Alternatively, such film may be completely omitted.

The pins 1 are ready for installation steps as illustrated in FIGS. 20 through 22. A solder layer 22 is preformed on each junction point 21 on a printed circuit board of an IC chip ceramic substrate 20. The junction points 21 having the solder layer 22 are aligned with the particular arrangement of the pins 1 supported on the ceramic plate 13. The pins 1 and the junction points 21 on the ceramic substrate 20 are aligned (as shown in FIG. 20) in such a manner that each pin 1 is pressed on the solder layer 22 at each junction point 21. The solder layers 22 are heated, thereby making solder electrical connections of the pins 1 to respective junction points 21 as shown in FIG. 21.

In a final step as shown in FIG. 22, the ceramic plate 13 supporting the pins is removed along with the electrically-conductive layer 10.

Consequently, the pins 1 are firmly mounted and electrically connected to the respective junction points 21 on the ceramic substrate 20 at their bottom ends while the upper ends are ready to receive electrodes of an IC chip device.

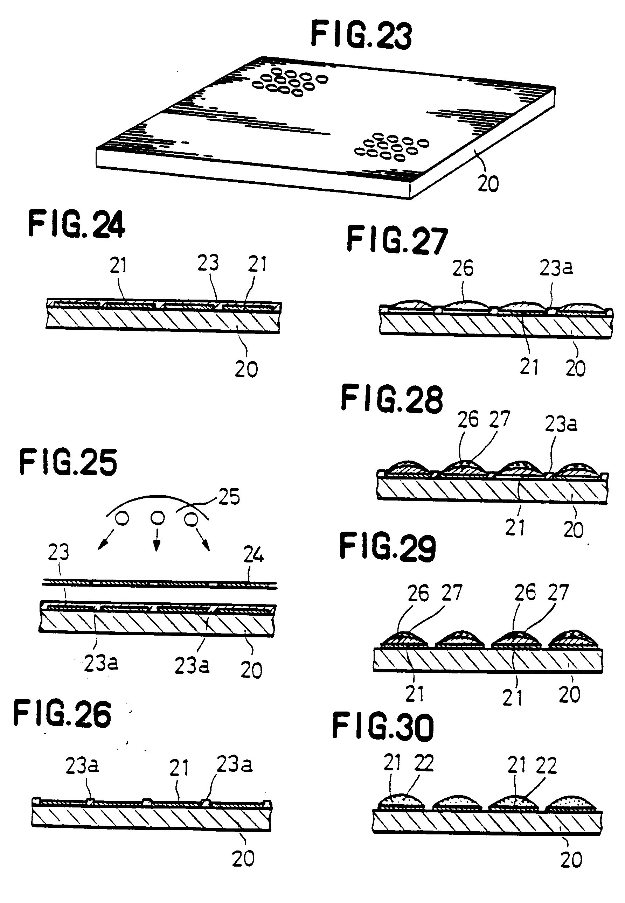

Illustrated in FIGS. 23 through 30 are steps to form the aforementioned ceramic substrate 20. The ceramic substrate 20 acting as an electrical-shielding plate and an electrode plate has printed circuits and the junction points 21 preformed on the surface (see FIG. 23). A photoresist layer 23 is applied on the surface (FIG. 24) covering such surface and the junction points 21.

In FIG. 25, the junction points 21 are covered with sections of a mask 24 to prevent exposure of light from a light source 25 whereas the photoresist layer 23 is exposed to light through openings of the mask 24. This will harden exposed regions 23a of the photoresist layer 23.

In the step of FIG. 26, the non-hardened regions of the photoresist layer 23 covering junction points 21 are conventionally removed by washing, etching or scribing of the photoresist layer 23. This leaves the hardened exposed regions 23a of the photoresist layer 23 surrounding the junction points 21.

In FIG. 27, the junction points 21 are covered with either a silver or tin layer 26 by a conventional plating technique.

Also, in FIG. 28, a layer 27 of the complementary metal (either tin or silver) is formed on the layer 26.

In FIG. 29, the hardened regions 23a are removed by washing, etching or scribing means. Subsequently, in FIG. 30, heat processing is performed of the two layers 26 and 27 to form an alloy of the two metals acting as the above solder layer 22.

According to the electrical pin of the present invention, a chip device such as monolithic or hybrid ICs can be directly connected to a package substrate. The pin is so small that it is very effective to miniaturize connections of such IC devices, to reduce production cost, and to increase signal propagation speed.

The head member of the electrical pin is enlarged in diameter by the plated electrically-conductive material on the circumference of the pin member at one or both ends, thereby increasing the mounting strength as compared with the pin without such head member.

The formation of the electrode film material on the end surface of the head member helps to prevent such surface from oxidation during storage, delivery or when it is actually installed, thereby avoiding any problems such as degraded electric connection or generated heat due to increased resistance at the junction points.

Also, a large number of electrical pins are supported in an up-right position on a support plate in such a fashion to coincide with the electrodes of the chip device, printed circuit board or carrier member to be interconnected thereby. In this way, the arrangement of the pins is maintained and the support plate is subsequently removed, thereby allowing the pins to be soldered automatically at the head members on a carrier member.

The method of making the electrical pins according to the present invention allows the easy and simultaneous making of a large number of electrical pins having head members at both end surfaces.

All etching processing are conventional and well established. Additionally, two or more different photoetching technologies are not required to be used, thereby making the processing relatively simple, and the product quality very high and easily controllable.

## Claims

1. An assembly of electrical pins, each electrical pin comprising an electrically-conductive pin member (2) and electrically-conductive head members (3) at both ends of said pin member, characterised in that each pin member is substantially the same diameter over the entire length and said head members have an enlarged surface greater in diameter than the pin member, and means (10, 13) maintains the electrical pins in alignment at a predetermined pitch, said means (10, 13) comprising an electrically-conductive layer (10) disposed on the head members (3) at one end of said pin members (2), and a dielectric member (13) secured to said electrically-conductive layer (10).

2. An assembly of electrical pins as claimed in claim 1, characterized in that the end surfaces of said head members (3) are in the same plane of the end surfaces of each pin member (2).

3. An assembly of electrical pins as claimed in claim 1 or 2, characterized in that an electrically-conductive film (4) is disposed between said head members (3) at said one end of said pin members (2) and said electrically-conductive layer (10).

4. An electrical pin comprising an electrically-conductive pin member (2) and electrically-conductive head members (3) formed at both ends of said pin member, characterized in that said pin member is substantially the same diameter over the entire length and said head members (3) have an enlarged surface greater in diameter than said pin member (2) and in the same plane of the end surfaces of said pin member.

5. An electrical pin as claimed in claim 4, characterized in that at least one of said enlarged end surfaces of said head members (3) has an electrically-conductive film (4) disposed thereover.

6. A method of making an electrical pin assembly according to claim 1 comprising the steps of
arranging wire members (5) having metal pin members (2) coated with a layer (6) of different metal in alignment at a predetermined pitch;
applying a dielectric material (7) to the arrangement of wire members (5) which upon hardening forms an elongated member (8);
slicing the elongated member (8) perpendicular to the wire members (5) to obtain a processing member (9) having a thickness equal to the length of the electrical pins;
removing said metal layers (6) of said wire members (5) at both ends of said pin members (2) thereby forming recesses (11) around both ends of the pin members (2);
plating a conductive metal (3) in said recesses (11) forming head members (3) secured to the ends of the pin members (2); disposing an electrically-conductive layer (10) on the head members (3) at one end of the pin members (2); and
removing the dielectric material (7) and the metal layers (6).

7. A method of making electrical pins as claimed in claim 6, including the further step of forming a film electrode (4) on the head members (3) at one end of the pin members (2).

## Patentansprüche

1. Anordnung von elektrischen Stiften, von denen jeder ein elektrisch leitfähiges Stiftglied (2) und elektrisch leitfähige Kopfglieder (3) an beiden Enden des Stiftglieds aufweist, **dadurch gekennzeichnet,** daß jedes Stiftglied im wesentlichen den gleichen Durchmesser über die gesamte Länge hat und daß die Kopfglieder eine erweiterte Oberfläche haben, deren Durchmesser größer ist als die des Stiftglieds, und daß Mittel (10, 13) vorgesehen sind, die die elektrischen Stifte ausgerichtet in einer vorbestimmten Teilung halten, wobei diese Mittel (10, 13) eine elektrisch leitfähige Schicht (10) aufweisen, die auf den Kopfgliedern (3) an einem Ende der Stiftglieder (2) angeordnet ist, und daß ein dielektrisches Glied (13) an der elektrisch leitfähigen Schicht (10) befestigt ist.

2. Anordnung von elektrischen Stiften nach Anspruch 1, **dadurch gekennzeichnet,** daß die Endoberflächen der Kopfglieder (3) in derselben Ebene liegen wie die Endoberflächen jedes Stiftglieds (2).

3. Anordnung von elektrischen Stiften nach Anspruch 1 oder 2, **dadurch** **gekennzeichnet,** daß ein elektrisch leitfähiger Film (4) zwischen den Kopfgliedern (3) an dem einen Ende der Stiftglieder (2) und der elektrisch leitfähigen Schicht (10) angeordnet ist.

4. Elektrischer Stift mit einem elektrisch leitfähigen Stiftglied (2) und elektrisch leitfähigen Kopfgliedern (3), die an beiden Enden des Stiftglieds ausgebildet sind, **dadurch** **gekennzeichnet,** daß das Stiftglied im wesentlichen den gleichen Durchmesser über die gesamte Länge hat und daß die Kopfglieder (3) eine vergrößerte Oberfläche haben, deren Durchmesser größer ist als derjenige des Stiftglieds (2) und die in der gleichen Ebene wie die Endoberflächen des Stiftglieds liegt.

5. Elektrischer Stift nach Anspruch 4, **dadurch gekennzeichnet,** daß wenigstens eine der vergrößerten Endoberflächen des Kopfglieds (3) einen darauf aufgebrachten elektrisch leitfähigen Film (4) aufweist.

6. Verfahren zum Herstellen einer elektrischen Stiftanordnung nach Anspruch 1 mit den Schritten:
- Anordnen von Drahtgliedern (5), die Metall-Stiftglieder (2) beschichtet mit einer Schicht (6) aus unterschiedlichem Metall aufweisen, in Ausrichtung unter einer bestimmten Teilung,
- Aufbringen eines dielektrischen Materials (7) auf die Anordnung der Drahtglieder (5), das nach dem Aushärten ein längliches Glied (8) bildet,
- Aufschneiden des länglichen Gliedes (8) senkrecht zu den Drahtgliedern (5), um ein Verarbeitungsglied (9) zu erhalten, das eine Dicke hat, die gleich der Länge der elektrischen Stifte ist,
- Entfernen der Metallschichten (6) von den Drahtgliedern (5) an beiden Enden der Stiftglieder (2) und dabei Ausbilden von Ausnehmungen (11) um beide Enden der Stiftglieder (2) herum,
- Einbringen eines leitfähigen Metalls (3) in die Ausnehmungen (11) zur Bildung von Kopfgliedern (3), die an den Enden der Stiftglieder (2) befestigt sind, Aufbringen einer elektrisch leitfähigen Schicht (10) auf die Kopfglieder (3) an einem Ende der Stiftglieder (2) und
- Entfernen des dielektrischen Materials (7) und der Metallschichten (6).

7. Verfahren zum Herstellen elektrischer Stifte nach Anspruch 6 mit dem weiteren Schritt des Formens einer Filmelektrode (4) an den Kopfgliedern (3) an einem Ende der Stiftglieder (2).

## Revendications

1. Un assemblage de broches électriques, chaque broche électrique comprenant un corps de broche conducteur de l'électricité (2) et des têtes conductrices de l'électricité (3) aux deux extrémités du corps de broche, caractérisé en ce que chaque corps de broche a pratiquement le même diamètre sur la totalité de sa longueur, et les têtes ont une surface agrandie ayant un diamètre supérieur à celui du corps de broche, et des moyens (10, 13) maintiennent les broches électriques en alignement avec un pas prédéterminé, ces moyens (10, 13) comprenant une couche conductrice de l'électricité (10) disposée sur les têtes (3) à une extrémité des broches (2), et un élément diélectrique (13) fixé à la couche conductrice de l'électricité (10).

2. Un assemblage de broches électriques selon la revendication 1, caractérisé en ce que les surfaces d'extrémités des têtes (3) sont dans le même plan que les surfaces d'extrémités de chaque corps de broche (2).

3. Un assemblage de broches électriques selon la revendication 1 ou 2, caractérisé en ce qu'une pellicule conductrice de l'électricité (4) est disposée entre les têtes (3) à l'extrémité précitée des corps de broches (2) et la couche conductrice de l'électricité (10).

4. Une broche électrique comprenant un corps de broche conducteur de l'électricité (2) et des têtes conductrices de l'électricité (3) formées aux deux extrémités du corps de broche, caractérisée en ce que le corps de broche a pratiquement le même diamètre sur toute sa longueur et les têtes (3) ont une surface agrandie, de diamètre supérieur à celui du corps de broche (2), et elles sont dans le même plan que les surfaces d'extrémités du corps de broche.

5. Une broche électrique selon la revendication 4, caractérisée en ce qu'une pellicule conductrice de l'électricité (4) est disposée sur l'une au moins des surfaces d'extrémités agrandies des têtes (3).

6. Un procédé de fabrication d'un assemblage de broches électriques selon la revendication 1, comprenant les étapes suivantes :
on dispose en alignement avec un pas prédéterminé des fils (5) comportant des éléments de broche en métal (2) revêtus d'une couche (6) d'un métal différent;
on applique sur l'ensemble de fils (5) un matériau diélectrique (7) qui, en durcissant, forme un élément allongé (8);
on découpe l'élément allongé (8) perpendiculairement aux fils (5) pour obtenir un élément de fabrication (9) ayant une épaisseur égale à la longueur des broches électriques;
on enlève les couches de métal (6) des fils (5) aux deux extrémités des corps de broches (2), pour former ainsi des cavités (11) autour des deux extrémités des corps de broches (2);
on dépose un métal conducteur (3) dans les cavités (11), pour former des têtes (3) fixées aux extrémités des corps de broches (2);
on dispose une couche conductrice de l'électricité (10) sur les têtes (3), à une extrémité des corps de broche (2); et
on enlève le matériau diélectrique (7) et les couches de métal (6).

7. Un procédé de fabrication de broches électriques selon la revendication 6, comprenant l'étape supplémentaire de formation d'une électrode sous forme de pellicule (4) sur les têtes (3), à une extrémité des corps de broches (2).
